**Europäisches Patentamt**

**European Patent Office**

**Office européen des brevets**

(11) Veröffentlichungsnummer: **0 299 464**

**A1**

## EUROPÄISCHE PATENTANMELDUNG

(21) Anmeldenummer: **88111247.8**

(22) Anmeldetag: **13.07.88**

(51) Int. Cl.4: **H03L 5/00**

(30) Priorität: **17.07.87 DE 3723753**

(43) Veröffentlichungstag der Anmeldung:
**18.01.89 Patentblatt 89/03**

(84) Benannte Vertragsstaaten:
**DE FR GB IT NL**

(71) Anmelder: **Siemens Aktiengesellschaft Berlin
und München
Wittelsbacherplatz 2
D-8000 München 2(DE)**

(72) Erfinder: **Fenk, Josef, Dipl.-Ing.
Deutenhauserstrasse 10
D-8057 Eching/Ottenburg(DE)**

(54) **Monolithisch integrierbare, amplitudenregelbare Oszillator-Verstärker-Schaltung.**

(57) Amplitudenregelbare Oszillator-Differenzverstärkerschaltung, bei der durch die Minimierung störender parasistärer Kapazitäten die Bandbreite erweitert wird und bei der demzufolge zur Beaufschlagung eines Reglers ein unsymmetrisches Ausgangssignal vorgesehen ist und die Regelung die Ausgangssignalamplitude durch Variation des Differenzverstärkerstromes beeinflußt.

FIG 2

EP 0 299 464 A1

## Monolithisch integrierbare, amplitudenregelbare Oszillator-Verstärker-Schaltung

Die Erfindung betrifft eine monolithisch integrierbare, amplitudenregelbare Oszillator-Verstärker-Schaltung nach dem Oberbegriff des Patentanspruches 1.

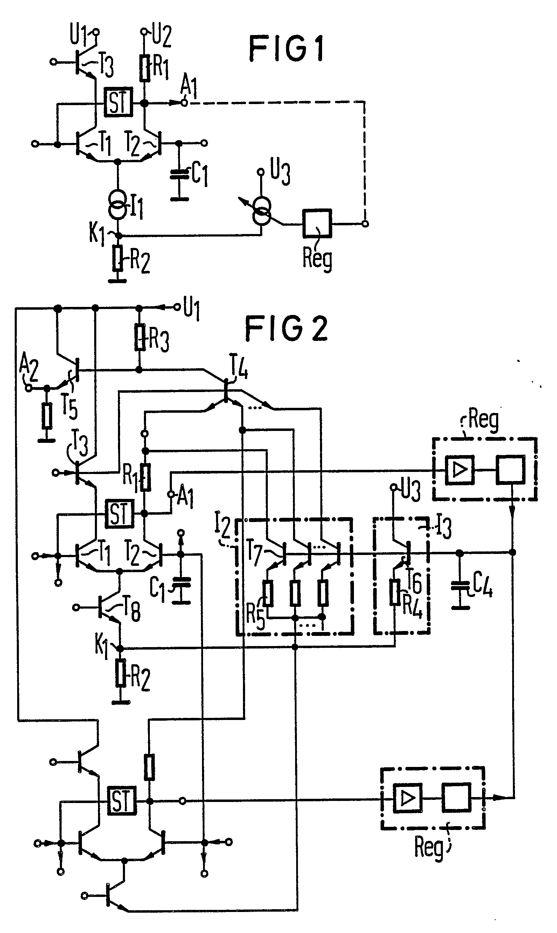

Amplitudenregelbare Oszillator-Verstärker, auch in Form von Differenzverstärkeranordnungen, sind unter anderem aus der DE-PS 30 41 392 bekannt. In Schaltungen nach FIG 1 aus der DE-PS 30 41 392 wird das Ausgangssignal an den Kollektoren der beiden Transistoren des Oszillator-Differenzverstärkerpaares symmetrisch ausgekoppelt und für den Regler zur Istwerterfassung unter Mittelwertbildung der Gleichkomponente und Gleichrichtung des hochfrequenten Anteiles herangezogen.

Bei Variation der Kollektorspannungen des Differenzverstärkerpaares stellt sich jedoch bei solchen Schaltungen zwischen den Kollektorspannungen der beiden Transistoren ein DC-Offset ein, der sich als Regelstörgröße bemerkbar machen kann. Außerdem wird die Bandbreite des Oszillator-Verstärkers durch den am ersten Transistor auftretenden Miller-Effekt und durch weitere parasitäre Kapazitäten negativ beeinflußt. Bei Oszillator-Differenzverstärkern ist nämlich im allgemeinen zwischen dem Basisanschluß des ersten Transistors und dem Kollektoranschluß des zweiten Transistors ein frequenzbestimmendes Schaltungsteil angeordnet. In dem durch das frequenzbestimmende Schaltungsteil und das Differenzverstärkerpaar gebildeten Schwingkreis führen die parasitären Kapazitäten der Transistoren sowie der eventuell an den Basisanschlüssen der Transistoren angeschlossenen Baugruppen zu einer Tiefpaßwirkung. Die Wirkung des Miller-Effektes kann, wie in Tietze/Schenk, Halbleiter-Schaltungs technik, 5. Aufl. 1980, S. 330-333 erwähnt, durch eine Kaskodeschaltung eliminiert werden. Der Einsatz einer solchen Schaltung ist jedoch bei symmetrischer Signalauskopplung an den Kollektoren der Oszillator-Verstärkertransistoren, wie in der vorgenannten DE-PS 30 41 392 nur in abgewandelter, wenig wirksamer Form möglich. Zwischen den Kollektoranschlüssen der in Emitterschaltung betriebenen Transistoren und den Emitteranschlüssen der in Basisschaltung betriebenen Transistoren sind nämlich in diesem Fall Lastwiderstände erforderlich, die der Eliminierung des Miller-Effektes entgegenstehen. Im Bereich des Transistors, dessen Kollektor mit dem frequenzbestimmenden Schaltungsteil verbunden ist, wird die Verstärkerbandbreite hauptsächlich durch die parasitäre Kollektor-Basis-Kapazität beeinträchtigt, die übrigen an diesem Transistor auftretenden parasitären Kapazitäten führen lediglich zu einer Veränderung der Resonanzfrequenz.

Die parasitäre Kollektor-Basis-Kapazität wird von der Sperrschichtkapazität zwischen Kollektor und Basis gebildet. Je größer die Spannung zwischen Kollektor und Emitter und daraus resultierend die Sperrspannung zwischen Kollektor und Basis ist, desto kleiner ist die Sperrschichtkapazität. Sollte bei vorgegebener Betriebsspannung der Lastwiderstand zwischen Kollektoranschluß und Betriebsspannung einen bestimmten, relativ hohen Wert nicht unterschreiten, so muß also der Emitteranschluß möglichst niederohmig an das Bezugspotential geschaltet werden, um in Abhängigkeit vom Strom eine möglichst hohe Spannung im Transistor und somit eine möglichst geringe parasitäre Kapazität zu erhalten.

Bei bekannten Oszillator-Differenzverstärkern, wie dem in der PS 30 41 392 DE beschriebenen, wirkt die Reglerausgangsspannung der Amplitudenregelung direkt auf das Potential eines Basisanschlusses des Differenzverstärkerpaares und verändert in Abhängigkeit von der Oszillator-Ausgangssignalamplitude somit den Arbeitspunkt des Differenzverstärkers. Die kapazitive Ausgangsimpedanz der Reglerschaltung belastet hierbei die Basisanschlüs se der Transistoren und begrenzt somit die Bandbreite der Verstärkerschaltung.
Eine andere Möglichkeit. den Arbeitspunkt des Differenzverstärkers zu ändern, liegt darin, die eingespeißten Emitterströme der Differenzverstärker-Transistoren zu variieren.

Aufgabe der Erfindung ist es, bei einem Oszillator-Differenzverstärker mit geregelter Ausgangsamplitude die durch parasitäre Schaltungselemente bedingte Verringerung der Bandbreite zu minimieren, ohne daß sich die zusätzliche Rauschleistung der Regelschleife am Ausgang des Oszillatorverstärkers störend bemerkbar macht.

Diese Aufgabe wird bei einer Oszillatorverstärkerschaltung der eingangs genannten Art durch die Merkmale des kennzeichnenden Teiles des Patentanspruches 1 gelöst.
Weiterbildungen der Erfindung sind in den Unteransprüchen gekennzeichnet.

FIG 1 zeigt das Schaltbild eines amplitudenregelbaren Oszillator-Differenzverstärkers, bei dem das Ausgangssignal in bekannter Weise symmetrisch an den Basisanschlüssen der Differenzverstärker-Transistoren ausgekoppelt werden kann und unsymmetrisch am Kollektor des zweiten Transistors $T_2$ entnommen wird, bei dem der Miller-Effekt im Bereich des ersten Transistors $T_1$ eliminiert wird, bei dem die Ausgangsamplitude in Abhängigkeit vom Reglerausgangssignal durch Variation der Emitterströme über eine spannungsgesteuerte Stromquelle verändert wird, wobei der Innenwiderstand der Stromquelle zwischen den Emitteranschlüssen und dem Basispotential klein gewählt werden kann und trotzdem der Verstärkungsfaktor, mit dem der zusätzliche Rauschanteil der Regelschleife an einen hochohmigen Lastwiderstand transformiert wird, kleiner als Eins sein kann.

FIG 2 zeigt als besonders vorteilhafte Ausführungsform eine Halbleiterschaltung, bei der die Phasendifferenz zwischen den Signalen der beiden angegebenen Signalausgänge minimiert ist. Außerdem werden Maßnahmen zur Reduzierung der vom zusätzlichen Rauschen der Regelschleife herrührenden Rauschleistung gezeigt sowie die Möglichkeit, mehrere Oszillatorverstärker mit einem gemeinsamen Stellglied und verschiedenen gemeinsam benutzten Schaltungselementen zu beschalten.

Der in FIG 1 gezeigte Oszillator-Verstärker wird durch eine monolithisch integrierbare Differenzverstärker-Schaltung realisiert, bei der der Kollektor des ersten Transistors $T_1$ unter Bildung einer Kaskodeschaltung unmittelbar mit dem Emitter eines dritten Transistors $T_3$ verbunden ist und der Kollektor dieses dritten Transistors $T_3$ an das erste Potential $U_1$ geschaltet ist, bei der der Kollektor des zweiten Transistors $T_2$ als ein erster Verstärkerausgang $A_1$ vorgesehen ist und über einen ersten Widerstand $R_1$ an ein zweites Potential $U_2$ geschaltet ist und die Emitter des ersten Transistors $T_1$ und des zweiten Transistors $T_2$ über eine erste Stromquelle mit dem Bezugspotential (Masse) verbunden sind und bei der als erste Stromquelle die Serienschaltung einer zweiten Stromquelle $I_1$ und einer mit dieser über einen ersten Schaltungsknoten $K_1$ verbundenen ersten Konstantstromquelle, insbesondere eines zweiten Widerstandes $R_2$ , vorgesehen ist, bei der für den Oszillatorverstärker eine Amplitudenregelung in Abhängigkeit vom Ausgangssignal vorgesehen ist und das Stellglied des Regelkreises aus einer ersten spannungsgesteuerten Stromquelle besteht, bei der der Steuerspannungseingang dieser ersten spannungsgesteuerten Stromquelle mit einer von einem Regler mit entkoppeltem Eingang Reg bereitgestellten Stellgröße beaufschlagt wird und bei der der Stromeingang der ersten spannungsgesteuerten Stromquelle an ein drittes Potential $U_3$ angeschlossen ist und ihr Stromausgang mit dem ersten Schaltungsknoten $K_1$ verbunden ist (FIG 1). Die zweite Stromquelle $I_1$ kann insbesondere aus einem in Basisschaltung betriebenen achten Transistor bestehen, wobei der Emitter dieses Transistors mit dem zweiten Widerstand $R_2$ über den ersten Knoten $K_1$ verbunden ist, dieser erste Knoten $K_1$ mit dem Stromausgang der ersten spannungsgesteuerten Stromquelle zusammengeschaltet ist und der Basisanschluß des achten Transistors an ein konstantes Potential geschaltet ist. Durch das konstante Basispotential des achten Transistors wird in der Basisschaltung ein weitgehend konstantes Potential am Emitteranschluß dieses Transistors eingestellt, so daß der zweite Widerstand, der zwischen diesem Emitteranschluß und dem Bezugspotential angeordnet ist, einen konstanten Strom führt. Wird dem ersten Knoten $K_1$ ein Teil dieses durch den zweiten Widerstand $R_2$ festgelegten Stromes durch die erste spannungsgesteuerte Stromquelle zugeführt, so fließt durch den achten Transistor ein um diesen zugeführten Stromanteil verminderter Strom. Die zur Einstellung der Arbeitspunkte der Transistoren erforderlichen Gleichpotentiale werden in bekannter Weise, z.B. durch Widerstände, den jeweiligen Transistoren zugeführt.

Eine Verbesserung der Regelkonstanz sowie die Eliminierung des Miller-Effektes, der im Bereich des über die Basis mit dem frequenzbestimmenden Schaltungsteil verbundenen Transistors auftritt, wird erfindungsgemäß dadurch ermöglicht, daß das Signal zur Ermittlung der Eingangsgröße eines Reglers unsymmetrisch an nur einem Kollektor des Oszillator-Differenzverstärkers abgeführt wird. Dadurch hat nämlich ein DC-Offset zwischen den beiden Kollektoren des Differenzverstärkerpaares keinen Einfluß auf den Reglereingang und außerdem kann der Kollektor des nicht zur Auskopplung des Reglereingangssignales dienenden Differenzverstärker-Transistors unmittelbar mit dem Emitter eines zweiten Transistors, der in Basisschaltung betrieben wird, unter Bildung einer Kaskodeschaltung zusammengeschaltet werden.

Minimale Signallaufzeiten im Hochfrequenzteil der Schaltung und eine dementsprechend größere Bandbreite lassen sich durch Einsparen von parasitären Kapazitäten im Bereich der Basisanschlüsse der Differenzverstärker-Transistoren erzielen. Um eine zusätzliche kapazitive Belastung der Basisanschlüsse durch die Reglerschaltung zu vermeiden, wirkt der Regler erfindungsgemäß nicht auf das Basispotential der Differenzverstärker-Transistoren, sondern beeinflußt die Ausgangsamplitude des Oszillators durch Steuerung des Differenzverstärkerstromes.

Wird das Eingangssignal des vorgesehenen Amplitudenregelkreises von einem unsymmetrischen Ausgangssignal des Oszillator-Differenzverstärkers abgeleitet, so wird das zusätzliche Rauschen der Regelschleife nicht, wie z.B. bei Schaltungen nach der DE-PS 30 41 392, im Differenzverstärkerpaar des Oszillator-Verstärkers kompensiert, sondern tritt als Störgröße an einem ersten Ausgang des Oszillator-Verstärkers auf.
Die Auswirkung des Rauschens der Regelschleife auf das Oszillator-Ausgangssignal läßt sich jedoch durch eine vierte Kapazität entsprechender Größe minimieren, die den Steuereingang der als Stellglied vorgesehenen spannungsgesteuerten Stromquelle mit dem Bezugspotential (Masse) verbindet.

Eine weitere Unterdrückung des von der Regelschleife herrührenden zusätzlichen Rauschleistungsanteiles des Oszillator-Ausgangssignales erreicht man dadurch, daß die als Stellglied dienende spannungsgesteuerte Stromquelle durch Transistorschaltungen mit starker Stromgegenkopplung realisiert ist, so daß der am Steuereingang dieser spannungsgesteuerten Stromquelle nicht unterdrückte Restanteil des zusätzlichen Rauschens der Regelschleife mit einem möglichst kleinen Verstärkungsfaktor, der insbesondere kleiner als 1 ist, am Ausgang des Oszillator-Verstärkers ansteht. Ein entsprechend kleiner Verstärkungsfaktor kann dadurch erzielt werden, daß der resultierende Innenwiderstand der zweiten spannungsgesteuerten Stromquelle $I_2$ nicht kleiner ist als der am Kollektor des zweiten Transistors angeschlossene Lastwiderstand der Oszillator-Verstärkerschaltung.

Ein hoher Innenwiderstand der zwischen den Emittern des Oszillator-Differenzverstärkertransistorpaares und dem Bezugspotential angeordneten steuerbaren Stromquelle begrenzt jedoch die über den Transistoren maximal anstehende Spannung und steht somit der Minimierung der Transistor-Sperrschicht-Kapazität entgegen. Deshalb ist bezüglich der Minimierung des zusätzlichen Rauschens der Regelschleife eine übliche spannungsgesteuerte Stromquelle als Stellglied wenig geeignet.

Die Ausgangsamplitude der Oszillator-Differenzverstärkerschaltung kann in Abhängigkeit von der Reglerausgangsgröße dadurch variiert werden, daß die Emitteranschlüsse der Oszillator-Differenzverstärker-Transistoren über eine Stromquelle mit dem Stromeingang einer Konstantstromquelle verbunden sind und der Stromausgang einer weiteren, spannungsgesteuerten Stromquelle ebenfalls an den Stromeingang dieser Konstantstromquelle geschaltet ist und die Emitterströme, deren Summe sich aus der Differenz des Stromes der Konstantstromquelle und des Stromes der spannungsgesteuerten Stromquelle ergibt, in Abhängigkeit vom Strom der spannungsgesteuerten Stromquelle, die als Stellglied dient und deren Steuereingang vom Reglerausgang angesteuert wird, variiert werden.

In Oszillator-Schaltungen, insbesondere für die Anwendung als Mischer-Oszillator, ist am Oszillatorverstärker neben dem Ausgang zum Amplitudenregler und dem typischerweise ein symmetrisches Signal führenden Ausgang zum Mischer oft noch ein weiterer, dritter Signalausgang erforderlich, der zum Anschluß an periphere Schaltungsgruppen, insbesondere an einen Zähler vorgesehen ist. Um Interferenzen zwischen dem Signal an diesem dritten Signalausgang $A_2$ und dem Signal, das am Hochpunkt des frequenzbestimmenden Schaltungsteiles ST ansteht, zu vermeiden, müssen die entsprechenden Anschluß-Pins der integrierten Schaltung einen möglichst großen Abstand voneinander haben, mindestens jedoch muß zwischen den Anschluß-Pins ein fest definiertes Bezugspotential vorgegeben werden. Diese Maßnahmen sind nur dann nicht erforderlich, wenn sichergestellt ist, daß das Ausgangssignal am dritten Signalausgang $A_2$ mit dem Signal am Hochpunkt des frequenzbestimmenden Schaltungsteiles ST zu jedem Zeitpunkt weitgehend in Phase ist.

Phasengleichheit zwischen dem Anschluß des frequenzbestimmenden Schaltungsteiles ST und dem dritten Signalausgang erreicht man dadurch, daß bei allen Elementen der Auskoppelschaltung zwischen dem Anschluß des frequenzbestimmenden Schaltungsteils ST und dem dritten Ausgang das jeweilige Ausgangssignal zum jeweiligen Eingangssignal in Phase ist.

Als solche Elemente sind ohm'sche Widerstände sowie Transistoren in Basis- oder Kollektorschaltung bekannt, wobei in den Transistoren im Mittel ein konstanter Strom fließen sollte.

Ein Oszillator-Verstärker, bei dem die Anschluß-Pins des dritten Verstärkerausganges $A_2$ und des Hochpunktes des frequenzbestimmenden Schaltungsteiles beliebig, auch nebeneinander angeordnet werden können, wobei das Auftreten störender Interferenzbildung zwischen Signalen dieser beiden Anschlüsse vermieden wird, wird erfindungsgemäß, wie in FIG 2 gezeigt, durch eine oben beschriebene Halbleiterschaltung realisiert, bei der außerdem die erste spannungsgesteuerte Stromquelle als Parallelschaltung einer zweiten spannungsgesteuerten Stromquelle $I_2$ und einer dritten spannungsgesteuerten Stromquelle $I_3$ ausgebildet ist und die Steuereingänge und die Stromausgänge dieser zweiten und dritten spannungsgesteuerten Stromquelle $I_2$, $I_3$ zusammengeschaltet sind, bei der der Stromeingang der dritten spannungsgesteuerten Stromquelle $I_3$ an das dritte Potential $U_3$ angeschlossen ist, der Stromeingang der zweiten spannungsgesteuerten Stromquelle $I_2$ mit dem an das zweite Potential $U_2$ angeschlossenen ersten Widerstand $R_1$ verbunden ist und der Strom der zweiten spannungsgesteuerten Stromquelle $I_2$ von gleicher Größe ist wie der Strom der dritten spannungsgesteuerten Stromquelle $I_3$, bei der ein viertes Potential, das insbesondere mit dem ersten Potential $U_1$ identisch sein kann, über einen dritten Widerstand $R_3$ an den Kollektoranschluß eines vierten Transistors $T_4$ und an den Basisanschluß eines fünften Transistors $T_5$ geschaltet ist, bei der der Basisanschluß des vierten Transistors $T_4$ insbesondere mit dem Basisanschluß des dritten Transistors $T_3$ zusammengeschaltet ist, der Kollektor des fünf-

ten Transistors $T_5$ an das vierte Potential angeschlossen ist, bei.der der Emitteranschluß des fünf-ten Transistors $T_5$ als zweiter Verstärkerausgang $A_2$ über eine Stromquelle, insbesondere einen Widerstand mit dem Bezugspotential (Masse) verbunden ist, und der Emitteranschluß des vierten Tran-sistors $T_4$ zur Beaufschlagung des ersten Wider-standes $R_1$ und des Stromeinganges der zweiten spannungsgesteuerten Stromquelle $I_2$ mit dem zweiten Potential $U_2$ vorgesehen ist, wobei die Ausgangssignale des ersten und des zweiten Verstär-kerausganges $A_1$, $A_2$ weitgehend phasengleich sind.

Der Kollektorstrom des vierten Transistors $T_4$ setzt sich im wesentlichen aus dem Kollektorstrom des zweiten Transistors $T_2$ und dem Strom der zweiten spannungsgesteuerten Stromquelle $I_2$ zu-sammen. Der konstante Strom durch den zweiten Widerstand $R_2$ setzt sich aus der Summe der Oszillator-Verstärkerströme, dem Strom der zweiten und dem Strom der dritten spannungsgesteuer-ten Stromquelle $I_2$, $I_3$ zusammen. Unter der Vor-aussetzung, daß die Ströme in den beiden Zweigen des Oszillator-Differenz-Verstärkers $T_1$, $T_2$ sowie die Ströme in der zweiten und der dritten spannungsgesteuerten Stromquelle $I_2$, $I_3$ jeweils nahezu gleich groß sind, ändern sich zwar bei Variation der Steuerspannung an den Steuereingängen der als Stellglied dienenden spannungsge-steuerten Stromquellen $I_2$, $I_3$ die Ströme des ersten und zweiten Transistors $T_1$, $T_2$ , der Strom im vierten Transistor $T_4$ bleibt jedoch nahezu konstant. Da der vierte Transistor $T_4$ in Basisschaltung und der fünfte Transistor $T_5$ in Kollektorschaltung ein-gesetzt sind, tritt zwischen ihrem Eingang und ihrem Ausgang jeweils keine nennenswerte Phasenverschiebung auf.

Bei monolithisch zu integrierenden Halbleiterschaltungen sollte die Chip-Fläche und die Zahl der nach außen führenden Anschlüsse minimiert werden. Werden mehrere ähnliche Baugruppen auf einem Chip vereint und zusammengeschaltet, so ist es folglich von Vorteil, solche Schaltungselemente, die in jeder Baugruppe erforderlich sind, nur einmal vorzusehen und allen Baugruppen gemeinsam zugehörig zu beschalten. Von besonderem Vorteil ist in diesem Fall das Einsparen von internen Kapazitäten, da diese eine relativ große Chip-Fläche benötigen und das Einsparen von externen Schaltungsmitteln, da diese jeweils einer eigenen Kontaktierung nach außen bedürfen.

Werden in einer Schaltung mehrere Oszillatoren mit ihren entsprechenden Oszillator-Verstärkern, insbesondere zur Erweite rung der Bandbreite, derart vorgesehen, daß jeweils nur einer der Oszillatoren in Betrieb ist, so hat man bei Oszillator-Verstärker-Schaltungen, die gemäß dem oben dargelegten Erfindungsgegenstand aufgebaut sind, die Möglichkeit, die Arbeitspunkt-Gleichspan-nungsversorgung des zweiten Transistors $T_2$, die erste Kapazität $C_1$, den zweiten Widerstand $R_2$, die erste spannungsgesteuerte Stromquelle, den vier-ten Transistor $T_4$, den fünften Transistor $T_5$ ein-schließlich seiner oben beschriebenen Beschaltung sowie die vierte Kapazität $C_4$ jeweils nur einmal vorzusehen.

FIG 2 zeigt eine Schaltungsanordnung mit zwei alternativ zu betreibenden Oszillatoren. Bei der Stromquelle· $I_2$ und dem Transitor $T_4$ ist angedeu-tet, daß die Zahl der anschließbaren Oszillatoren auch größer sein kann. Die Schaltungselemente die für jeden verwendeten Oszillator getrennt erforderlich sind und jeweils die gleiche Funktion erfüllen, sind mit gleichen Bezugszeichen versehen. Zur besseren Unterscheidbarkeit sind die Bezugszeichen der Elemente des zweiten Oszillators jeweils mit einem Strich gekennzeichnet.

Die erste spannungsgesteuerte Stromquelle kann, wie in FIG 2 gezeigt, insbesondere durch eine Halbleiterschaltung realisiert werden, bei der die dritte spannungsgesteuerte Stromquelle $I_3$ von einem sechsten Transistor $T_6$ gebildet wird, dessen Emitteranschluß über einen vierten Widerstand $R_4$ mit dem Stromausgang der dritten spannungsge-steuerten Stromquelle $I_3$ verbunden ist, bei der als zweite spannungsgesteuerte Stromquelle $I_2$ minde-stens ein siebter Transistor $T_7$ und bei Schaltungen nach Anspruch 4 für jeden zusätzlichen Oszillator ein weiterer Transistor vorgesehen ist, wobei der Emitteranschluß des siebten Transistors $T_7$ über einen fünften Widerstand $R_5$ und die Emitteran-schlüsse der weiteren die zweite spannungsgesteuerte Stromquelle bildenden Transistoren über je einen weiteren Widerstand mit dem Stromausgang der zweiten und der dritten spannungsge-steuerten Stromquelle $I_2$, $I_3$ verbunden sind, bei der die Basisanschlüsse der die zweite und die dritte spannungsgesteuerte Stromquelle $I_2$, $I_3$ bil-denden Transistoren $T_6$, $T_7$... unmittelbar mit den Steuereingängen der zweiten und der dritten span-nungsgesteuerten Stromquelle $I_2$, $I_3$ verbunden sind, bei der der Kollektoranschluß des sechsten Transistors $T_6$ als Stromeingang der dritten span-nungsgesteuerten Stromquelle $I_3$ an das dritte Po-tential $U_3$ geschaltet ist, bei der die Kollektoranschlüsse der die zweite spannungsgesteuerte Stromquelle $I_2$ bildenden Transistoren $T_7$, ... als Stromeingang der zweiten spannungsgesteuerten Stromquelle $I_2$ jeweils an den Emitteranschluß des vierten Transistors $T_4$ geschaltet sind, wobei der vierte Transistor insbesondere für jeden Kollektoranschluß der zweiten spannungsgesteuer-ten Stromquelle $I_2$ einen eigenen Emitter vorgese-hen hat, bei der der Strom der zweiten und der Strom der dritten spannungsgesteuerten Strom-quelle $I_2$, $I_3$ jeweils von gleicher Größe sind und wobei sowohl der vierte Widerstand $R_4$, als auch der aus der Parallelschaltung des fünften Widerstandes $R_5$ mit den evtl. weiteren, in der zweiten spannungsgesteuerten Stromquelle $I_2$ enthaltenen Widerständen resultierende Widerstandswert, jeweils größer als der erste Widerstand $R_1$ ist.

Die Schaltung der einzelnen Stromquellen ist beliebig wählbar. Als Transistoren können bei entsprechender Beschaltung sowohl bipolare NPN- oder PNP-Transistoren, als auch Feldeffekttransistoren eingesetzt werden.

## Ansprüche

Monolithisch integrierbare, amplitudenregelbare OszillatorVerstärker-Schaltung, die von einem aus einem ersten Transistor ($T_1$) und aus einem mit diesem emittergekoppelten zweiten Transistor ($T_2$) bestehenden Differenzverstärker gebildet ist, bei der der Basisanschluß des ersten Transistors ($T_1$) an ein frequenzbestimmendes Schaltungsteil (ST) geschaltet ist, die Basis des ersten Transistors ($T_1$) und die Basis des zweiten Transistors ($T_2$) mit einer Gleichspannung beaufschlagt sind, der Basisanschluß des zweiten Transistors ($T_2$) über eine erste Kapazität ($C_1$) an das Bezugspotential (Masse) angeschlossen ist und das frequenzbestimmende Schaltungsteil (ST) an den Kollektor des zweiten Transistors ($T_2$) geschaltet ist, wobei das frequenzbestimmende Schaltungsteil (ST) insbesondere unter Vermittlung von Kapazitäten an den Oszillator-Verstärker angeschlossen ist, bei der der Kollektoranschluß des ersten Transistors ($T_1$) über einen Schaltungsteil an ein erstes Potential ($U_1$) angeschlossen ist, der Kollektor des zweiten Transistors ($T_2$) über einen Schaltungsteil an ein zweites Potential ($U_2$) geschaltet ist und die Emitter des ersten Transistors ($T_1$) und des zweiten Transistors ($T_2$) über eine erste Stromquelle, insbesondere einem Widerstand, mit dem Bezugspotential (Masse) verbunden sind, **dadurch gekennzeichnet,** daß der Kollektor des ersten Transistors ($T_1$) unter Bildung einer Kaskodeschaltung unmittelbar mit dem Emitter eines dritten Transistors ($T_3$) verbunden ist, der Kollektor dieses dritten Transistors ($T_3$) an das erste Potential ($U_1$) geschaltet ist und die Basis des dritten Transistors ($T_3$) in bekannter Weise mit einer Gleichspannung beaufschlagt ist, daß der Kollektor des zweiten Transistors ($T_2$) als ein erster Verstärkerausgang ($A_1$) vorgesehen ist und über einen ersten Widerstand ($R_1$) an das zweite Potential ($U_2$) geschaltet ist, daß als erste Stromquelle die Serienschaltung einer zweiten Stromquelle ($I_1$) und einer mit dieser über einen ersten Schaltungsknoten ($K_1$) verbundenen ersten Konstantstromquelle, insbesondere eines zweiten Widerstandes ($R_2$), vorgesehen ist, daß für den Oszillatorverstärker eine Amplitudenregelung in Abhängigkeit vom Ausgangssignal vorgesehen ist und das Stellglied des Regelkreises aus einer ersten spannungsgesteuerten Stromquelle besteht, daß der Steuerspannungseingang dieser ersten spannungsgesteuerten Stromquelle mit einer von einem Regler (Reg) bereitgestellten Stellgröße beaufschlagt wird und daß der Stromeingang der ersten spannungsgesteuerten Stromquelle an ein drittes Potential ($U_3$) angeschlossen ist und ihr Stromausgang mit dem ersten Schaltungsknoten ($K_1$) verbunden ist (FIG 1).

2. Halbleiterschaltung nach Anspruch 1,
**dadurch gekennzeichnet,**
daß die zweite Stromquelle ($I_1$) durch einen achten Transistor ($T_8$) realisiert ist, daß der Kollektoranschluß des achten Transistors ($T_8$) mit den Emitteranschlüssen des ersten und des zweiten Transistors ($T_1$, $T_2$) zusammengeschaltet ist, daß der Emitter des achten Transistors ($T_8$) mit dem ersten Knoten ($K_1$) verbunden ist und daß die Basis des achten Transistors mit einem ersten Referenzpotential beaufschlagt wird.

3. Halbleiterschaltung nach Anspruch 1 oder 2,
**dadurch gekennzeichnet,**
daß die erste spannungsgesteuerte Stromquelle als Parallelschaltung einer zweiten spannungsgesteuerten Stromquelle ($I_2$) und einer dritten spannungsgesteuerten Stromquelle ($I_3$) besteht, wobei die Steuereingänge und die Stromausgänge dieser zweiten und dritten spannungsgesteuerten Stromquelle ($I_2$, $I_3$) zusammengeschaltet sind, daß der Stromeingang der dritten spannungsgesteuerten Stromquelle ($I_3$) an das dritte Potential ($U_3$) angeschlossen ist, daß der Stromeingang der zweiten spannungsgesteuerten Stromquelle mit dem an das zweite Potential ($U_2$) angeschlossenen ersten Widerstand ($R_1$) verbunden ist und der Strom der zweiten spannungsgesteuerten Stromquelle ($I_2$) von gleicher Größe ist wie der Strom der dritten spannungsgesteuerten Stromquelle ($I_3$), daß ein viertes Potential, das insbesondere mit dem ersten Potential ($U_1$) identisch sein kann, über einen dritten Widerstand ($R_3$) an den Kollektoranschluß eines vierten Transistors ($T_4$) und an den Basisanschluß eines fünften Transistors ($T_5$) geschaltet ist, daß der Basisanschluß des vierten Transistors ($T_4$) insbesondere mit dem Basisanschluß des dritten Transistors ($T_3$) zusammengeschaltet ist, daß der Kollektor des fünften Transistors ($T_5$) an das vierte Potential angeschlossen ist, daß der Emitteranschluß des fünften Transistors ($T_5$) als zweiter Verstärkerausgang ($A_2$) über eine Stromquelle, insbesondere einen Widerstand mit dem Bezugspotential (Masse) verbunden ist und daß der Emitteranschluß des vierten Transistors ($T_4$) zur Beaufschlagung des ersten Widerstandes ($R_1$) und des

Stromeinganges der zweiten spannungsgesteuerten Stromquelle ($I_2$) mit dem zweiten Potential ($U_2$) vorgesehen ist, wobei die Ausgangssignale des ersten und des zweiten Verstärkerausganges ($A_1$, $A_2$) weitgehend phasengleich sind.

4. Halbleiterschaltung nach Anspruch 1, 2 oder 3,
**dadurch gekennzeichnet,**
daß der Steuereingang der ersten spannungsgesteuerten Stromquelle unter Vermittlung einer vierten Kapazität ($C_4$) gegen das Bezugspotential (Masse) geschaltet ist.

5. Halbleiterschaltung, bestehend aus mehreren Oszillator-Verstärkern nach Anspruch 2, 3 oder 4,
**dadurch gekennzeichnet,**
daß die Arbeitspunkt-Gleichstromversorgung des zweiten Transistors ($T_2$), die erste Kapazität ($C_1$), der zweite Widerstand ($R_2$), die erste spannungsgesteuerte Stromquelle ($I_1$), die vierte Kapazität ($C_4$), der vierte Transistor ($T_4$) und der fünfte Transistor ($T_5$) einschließlich seiner in Anspruch 3 beschriebenen Beschaltung nur einmal vorgesehen sind und allen Oszillator-Verstärker-Schaltungen gemeinsam sind.

6. Halbleiterschaltung nach einem der Ansprüche 2, 3, 4 oder 5,
**dadurch gekennzeichnet,**
daß die dritte spannungsgesteuerte Stromquelle ($I_3$) von einem sechsten Transistor ($T_6$) gebildet wird, dessen Emitteranschluß über einen vierten Widerstand ($R_4$) mit dem Stromausgang der dritten spannungsgesteuerten Stromquelle ($I_3$) verbunden ist, daß als zweite spannungsgesteuerte Stromquelle ($I_2$) mindestens ein siebter Transistor ($T_7$) und bei Schaltungen nach Anspruch 4 für jeden zusätzlichen Oszillator ein weiterer Transistor vorgesehen ist, wobei der Emitteranschluß des siebten Transistors ($T_7$) über einen fünften Widerstand ($R_5$) und die Emitteranschlüsse der weiteren die zweite spannungsgesteuerte Stromquelle bildenden Transistoren über je einen weiteren Widerstand mit dem Stromausgang der zweiten und der dritten spannungsgesteuerten Stromquelle ($I_2$, $I_3$) verbunden sind, daß die Basisanschlüsse der die zweite und die dritte spannungsgesteuerte Stromquelle ($I_2$, $I_3$) bildenden Transistoren ($T_6$, $T_7$...) unmittelbar mit den Steuereingängen der zweiten und der dritten spannungsgesteuerten Stromquelle ($I_2$, $I_3$) verbunden sind, daß der Kollektoranschluß des sechsten Transistors ($T_6$) als Stromeingang der dritten spannungsgesteuerten Stromquelle ($I_3$) an das dritte Potential ($U_3$) geschaltet ist und daß die Kollektoranschlüsse der die zweite spannungsgesteuerte Stromquelle ($I_2$) bildenden Transistoren ($T_7$,...) als Stromeingang der zweiten spannungsgesteuerten Stromquelle ($I_2$) jeweils an das zweite Potential, insbesondere an den Emitteranschluß

des vierten Transistors ($T_4$) geschaltet sind, wobei der vierte Transistor insbesondere für jeden Kollektoranschluß der zweiten spannungsgesteuerten Stromquelle ($I_2$) einen eigenen Emitter vorgesehen hat.

7. Halbleiterschaltung nach einem der vorhergehenden Ansprüche,
**dadurch gekennzeichnet,**
daß der Strom der zweiten und der Strom der dritten spannungsgesteuerten Stromquelle ($I_2$, $I_3$) jeweils von gleicher Größe sind.

8. Halbleiterschaltung nach Anspruch 6 oder 7,
**dadurch gekennzeichnet,**
daß sowohl der vierte Widerstand ($R_4$), als auch der aus der Parallelschaltung des fünften Widerstandes ($R_5$) mit den evtl. weiteren, in der zweiten spannungsgesteuerten Stromquelle ($I_2$) enthaltenen Widerständen resultierende Widerstandswert, jeweils größer als der erste Widerstand ($R_1$) ist.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 588 968 (D.T. WILE)<br>* Spalte 1, Zeile 51 - Spalte 4, Zeile 41; Figuren 1,2 *<br>--- | 1 | H 03 L 5/00 |
| A | DE-A-2 803 430 (SIEMENS)<br>* Zusammenfassung; Figuren *<br>--- | 1 | |
| A,D | EP-A-0 051 179 (SIEMENS)<br>* Zusammenfassung, Figur 1 *<br>--- | 1 | |
| A | PATENT ABSTRACTS OF JAPAN, Band 10, Nr. 309, 21. Oktober 1986, Seite 27 E 447;<br>& JP-A-61 121 504 (MATSUSHITA ELECTRIC IND. CO., LTD) 09-06-1986<br>--- | 1 | |
| A,D | U. TIETZE et al.:<br>"Halbleiter-Schaltungstechnik", 5. Auflage, 1980, Seiten 328-333, Springer Verlag, Berlin, DE<br>* Seite 329, Zeile 18 - Seite 333, Zeile 16; Figuren 14.4,14.6 *<br>----- | 1 | |

| | |
|---|---|
| | **RECHERCHIERTE SACHGEBIETE (Int. Cl.4)** |
| | H 03 L<br>H 03 G |

Der vorliegende Recherchenbericht wurde für alle Patentansprüche erstellt

| Recherchenort | Abschlußdatum der Recherche | Prüfer |
|---|---|---|
| DEN HAAG | 17-10-1988 | DHONDT I.E.E. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
    ........................................................
& : Mitglied der gleichen Patentfamilie, übereinstimmendes
    Dokument